(19) Europäisches Patentamt
European Patent Office
Office européen des brevets

(11) **EP 3 560 617 B1**

(12) **EUROPEAN PATENT SPECIFICATION**

(45) Date of publication and mention
of the grant of the patent:
**24.02.2021 Bulletin 2021/08**

(21) Application number: **17885409.7**

(22) Date of filing: **01.12.2017**

(51) Int Cl.:
***G06F 30/00*** *(2020.01)*

(86) International application number:
**PCT/JP2017/043231**

(87) International publication number:
**WO 2018/116787 (28.06.2018 Gazette 2018/26)**

(54) **METHOD FOR EVALUATING DEFORMATION PERFORMANCE OF STEEL PIPE AND METHOD FOR MANUFACTURING STEEL PIPE**

VERFAHREN ZUR BEWERTUNG DER VERFORMUNG EINES STAHLROHRS UND VERFAHREN ZUR HERSTELLUNG EINES STAHLROHRS

PROCÉDÉ D'ÉVALUATION DES PERFORMANCES DE DÉFORMATION D'UN TUYAU EN ACIER ET PROCÉDÉ DE FABRICATION D'UN TUYAU EN ACIER

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **20.12.2016 JP 2016246605**

(43) Date of publication of application:
**30.10.2019 Bulletin 2019/44**

(73) Proprietor: **JFE Steel Corporation**
**Tokyo 100-0011 (JP)**

(72) Inventors:
• **TAJIKA Hisakazu**
**Tokyo 100-0011 (JP)**

• **IGI Satoshi**
**Tokyo 100-0011 (JP)**

(74) Representative: **Grünecker Patent- und Rechtsanwälte**
**PartG mbB**
**Leopoldstraße 4**
**80802 München (DE)**

(56) References cited:
**EP-A1- 2 752 255       EP-A1- 2 818 260**
**WO-A1-2004/080623   WO-A1-2013/031879**
**CA-A1- 2 977 922       JP-A- S53 104 563**
**JP-A- 2000 190 030     JP-A- 2009 243 907**

**Description**

Technical Field

The present invention relates to a method of evaluating deformability of steel pipe, such as a UOE steel pipe, manufactured through a pipe expanding step performed using a die during manufacture, and also relates to a method of manufacturing steel pipe using the method of evaluating deformability of steel pipe .

Background Art

To meet growing demand for energy resources, such as gas and oil, an increasing number of gas and oil fields have been newly developed in recent years. Accordingly, more and more pipelines have been constructed in seismic zones and permafrost zones. In seismic zones and permafrost zones (discontinuous permafrost zones, in particular), the ground may be significantly deformed by liquefaction, fault displacement, frost heaving, or thawing. Buried pipelines may be deformed by the impact of large deformation of the ground.

In an environment where large ground deformation occurs, pipelines are subjected to the action of large deformation even after being plastically deformed. If subjected to excessive deformation, steel pipes are bent, buckled on the compressed side, and subsequently ruptured on the tension side. Since rupture of pipelines may lead to accidental leakage of gas or the like, steel pipes of the pipelines are required to have deformability sufficient to prevent such rupture.

A UOE steel pipe used for pipelines, such as those described above, has a wavy shape formed by the effect of pipe expansion performed by a die in the outer diameter direction. Because of this wavy shape, the bending rigidity of the steel pipe is not uniform and varies. This causes bending strain to be developed in some parts that are prone to bending. This is followed by the occurrence of buckling in the same parts.

To allow the steel pipe to bend without buckling, that is, to improve deformability of the steel pipe, it is necessary that the steel pipe be improved in terms of both material and shape.

In terms of shape, the steel pipe ideally has a perfect circular shape, a uniform wall thickness with no variation, and a uniform shape in its radial direction.

It is industrially impossible, however, to manufacture perfectly circular steel pipes with no variation in shape, and it is necessary to control the shape characteristics of products within certain manufacturing tolerances.

Patent Literature 1 describes a technique in which a value called "undulation wavelength ratio D" is defined, and the value of the undulation wavelength ratio D is set to 0.8 or less. Patent Literature 1 states that if the undulation wavelength ratio D is 0.8 or less, improved buckling resistance or deformability is achieved.

Patent Literature 1 explains that the evaluation is made on the assumption that the amplitude of the wavy shape is a constant value, specifically, 0.73 mm = 0.06% OD.

Citation List

Patent Literature

PTL 1: Japanese Patent No. 5447461

Summary of Invention

Technical Problem

In the technique described in Patent Literature 1, the calculation is made on the assumption that all "undulations" have the same amplitude. Patent Literature 1 does not specifically describe how the amplitude affects resistance to buckling.

Also, the technique described in Patent Literature 1 assumes a wavy shape of the same frequency, and does not assume waves of different wavelengths or random waves.

As described above, in the technique described in Patent Literature 1, the shape of a steel pipe to be subjected to pipe expansion is designed and evaluated on the assumption that the shape of the steel pipe has a single frequency.

However, the shape of the steel pipe changes its wavy shape depending on how the pipe expansion is controlled (e.g., the pipe expansion pitch used). There is a tendency, for example, that if the pipe expansion is performed with a fine pitch, a short-period small-amplitude wave is obtained, whereas if the pipe expansion is performed with a coarse pitch, a long-period large-amplitude wave is obtained. The pipe expansion generally involves using a tool called a die, which is shorter than the steel pipe length. The die placed inside the steel pipe applies pressure to the steel pipe in the outer diameter direction to partially expand it. After this partial pipe expansion, the die moves to the next pipe expansion position to repeat the pipe expansion operation. In the present invention, the pipe expansion pitch refers to the distance the die travels each time to reach the next pipe expansion position in the pipe expansion operation.

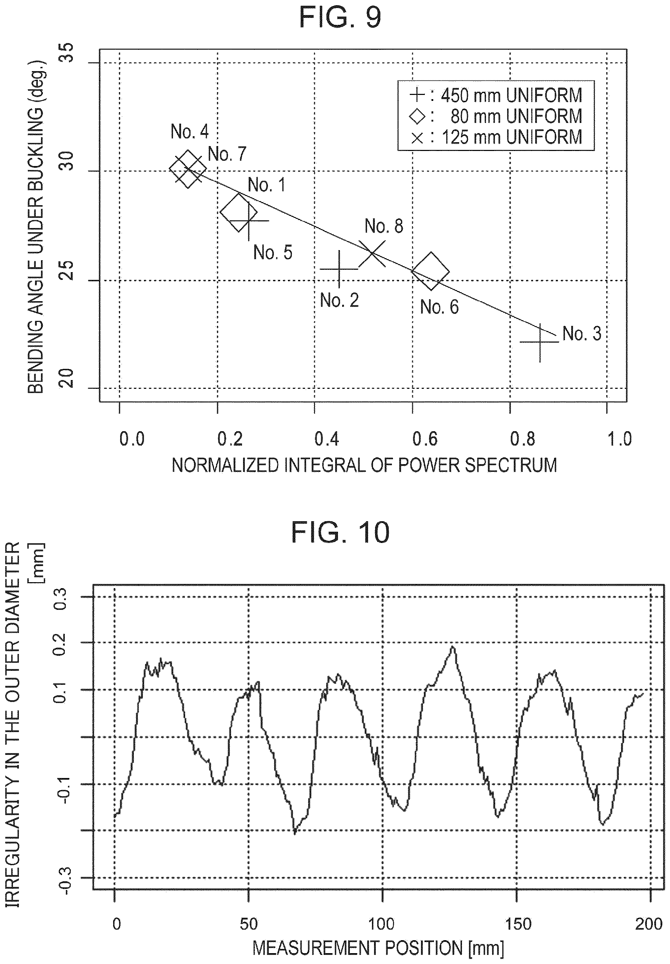

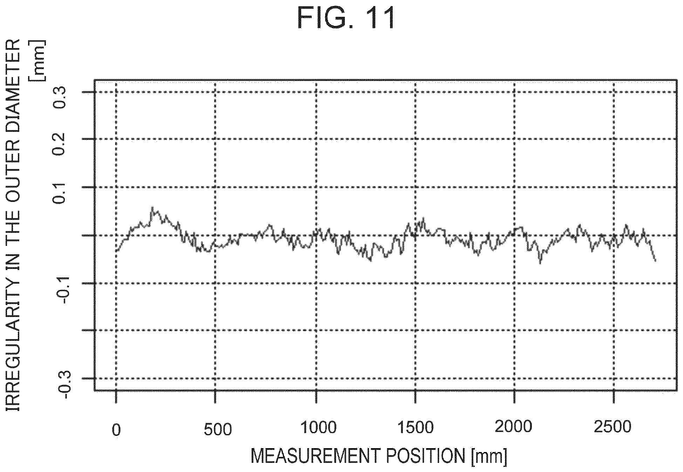

In practice, if pipe expansion is performed with a coarse pitch, such as a 450 mm pitch, the resulting shape of the steel pipe has nearly the shape of a sine curve, such as that shown in Fig. 10, whereas if pipe expansion is performed with a fine pitch, such as an 80 mm pitch, the resulting superimposition of wavy shapes produces a random wavy shape, such as that shown in Fig. 11, instead of a simple sine curve.

In Figs. 10 and 11, the horizontal axis represents the measurement position (mm) and the vertical axis represents the irregularity in the outer diameter direction (mm). Here, the irregularity in the outer diameter direction refers to the amount of deviation from a mean diameter determined by measuring the outer shape of the steel pipe.

The description above indicates that deformability of the steel pipe cannot be evaluated on the basis only of the amplitude or wavy shape of the shape.

The present invention has been made to solve the problems described above. An object of the present invention is to provide, for a steel pipe manufactured through a pipe expanding step performed using a die, a method of evaluating deformability of steel pipe with which deformability of the steel pipe can be evaluated regardless of whether the pitch of pipe expansion is coarse or fine, and also to provide a method of manufacturing steel pipe using the method of evaluating deformability of steel pipe . Solution to Problem

For the shapes of actual steel pipes that cannot be evaluated on the basis of the amplitude or wavy shape of the outer shape of the steel pipe, the present inventor carried out studies to develop methods for evaluating deformability of the steel pipe. The present inventor focused on the fact that even when the outer shape of the steel pipe is a shape having a random wavy shape, the resulting complex wave has power in each period. Spectral analysis performed on the outer shape of the steel pipe yielded findings indicating that there is a correlation between the power spectrum and the deformability of the steel pipe. The present inventor has completed the present invention on the basis of these findings. Here, the power spectrum refers to an actual signal strength distribution in each wavelength (or wave number), and is obtained by dividing signal power into predetermined frequency bands and representing power in each band as a function of frequency.

Specifically, the present invention includes the following.

(1) A method of evaluating deformability of steel pipe according to the present invention is a method for evaluating deformability of a steel pipe manufactured through a pipe expanding step performed using a die. The method of evaluating deformability of steel pipe includes a outer shape acquiring step of measuring a shape of the steel pipe to acquire a outer shape; a power spectrum acquiring step of acquiring a power spectrum from a wavy shape of the acquired outer shape; and a determining step of integrating the acquired power spectrum for a predetermined wavelength range and determining deformability on the basis of the resulting integral.

(2) In the method of evaluating deformability of steel pipe according to (1), if the integral is less than or equal to a predetermined value, the determining step determines that a predetermined deformability level is satisfied.

(3) A method of manufacturing steel pipe according to the present invention is a method for manufacturing a steel pipe on the basis of the method of evaluating deformability of steel pipe according to (1) or (2). If the determining step of the method of evaluating deformability of steel pipe determines that the deformability does not satisfy a predetermined deformability level, a pipe expansion pitch in the pipe expanding step performed using the die is reduced. Advantageous Effects of Invention

The present invention includes a outer shape acquiring step of measuring a shape of a steel pipe to acquire a outer shape of the steel pipe, a power spectrum acquiring step of acquiring a power spectrum from a wavy shape of the acquired outer shape, and a determining step of integrating the acquired power spectrum for a predetermined wavelength range and determining deformability on the basis of the resulting integral. This enables accurate evaluation of deformability of the steel pipe regardless of whether the pitch of pipe expansion is coarse or fine.

Brief Description of Drawings

[Fig. 1] Fig. 1 is an explanatory diagram of a method of evaluating deformability of steel pipe according to an embodiment of the present invention.
[Fig. 2] Fig. 2 is a schematic diagram illustrating the shape of a steel pipe manufactured through a pipe expanding step using a die, dealt with by the present invention.
[Fig. 3] Fig. 3 is a diagram showing a power spectrum obtained when the pipe expansion pitch is 450 mm.
[Fig. 4] Fig. 4 is a diagram showing a power spectrum obtained when the pipe expansion pitch is 125 mm.
[Fig. 5] Fig. 5 is a diagram showing a power spectrum obtained when the pipe expansion pitch is 80 mm.

[Fig. 6] Fig. 6 is a diagram showing a random wave for normalization of a power spectrum.

[Fig. 7] Fig. 7 is a diagram showing the power spectrum of the random wave shown in Fig. 6.

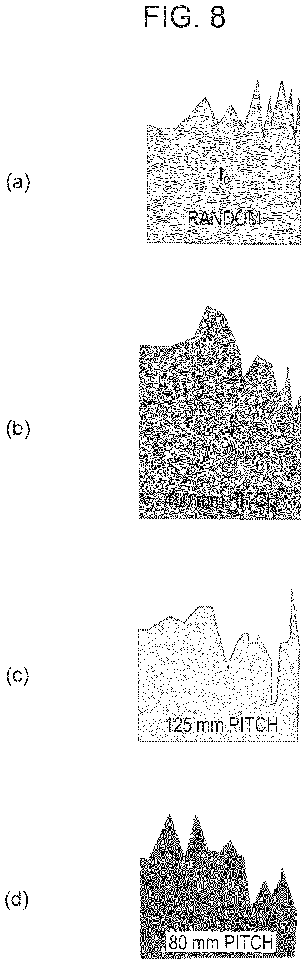

[Fig. 8] Fig. 8(a) is a diagram showing an area obtained by integrating the power spectrum of the random wavy shape, Fig. 8(b) is a diagram showing an area obtained by integrating the power spectrum of the wavy shape of a outer shape corresponding to a pipe expansion pitch of 450 mm, Fig. 8(c) is a diagram showing an area obtained by integrating the power spectrum of the wavy shape of a outer shape corresponding to a pipe expansion pitch of 125 mm, and Fig. 8(d) is a diagram showing an area obtained by integrating the power spectrum of the wavy shape of a outer shape corresponding to a pipe expansion pitch of 80 mm.

[Fig. 9] Fig. 9 is a graph showing experimental results in EXAMPLE, specifically, a relationship between the normalized integral of the power spectrum and the bending angle (in degrees) under buckling.

[Fig. 10] Fig. 10 is a diagram showing a wavy shape of the outer shape of a steel pipe obtained when the pipe expansion pitch is 450 mm.

[Fig. 11] Fig. 11 is a diagram showing a wavy shape of the outer shape of a steel pipe obtained when the pipe expansion pitch is 80 mm.

Description of Embodiments

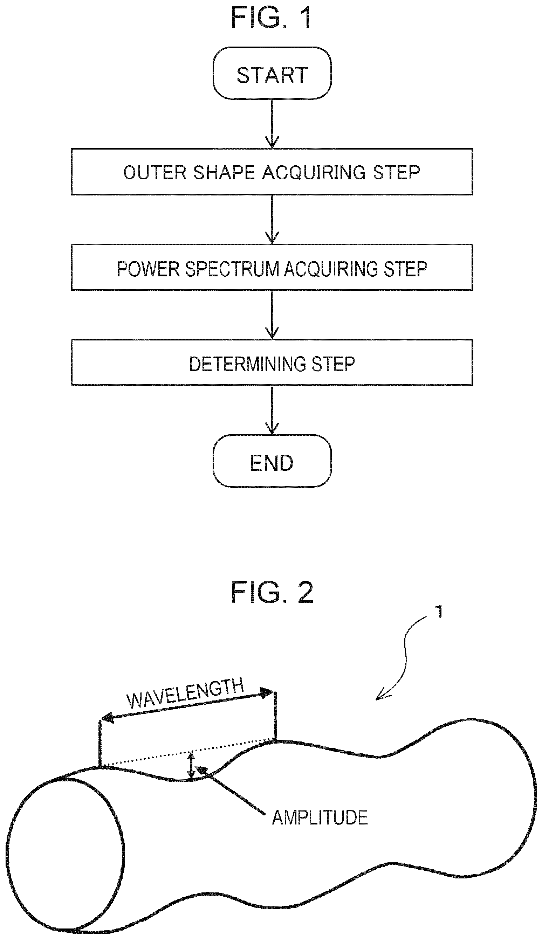

A method of evaluating deformability of steel pipe according to an embodiment of the present invention is used to evaluate a steel pipe manufactured through a pipe expanding step using a die. As illustrated in Fig. 1, the evaluation method includes a outer shape acquiring step of acquiring a wavy shape of a outer shape of a steel pipe, a power spectrum acquiring step of acquiring a power spectrum from the acquired wavy shape of the outer shape, and a determining step of determining deformability of the steel pipe. For example, a deformability evaluation apparatus that performs the method of evaluating deformability of steel pipe of the present invention includes a outer shape acquiring unit, a power spectrum acquiring unit, and a determining unit. The steel pipe deformability evaluation process illustrated in Fig. 1 starts when a signal instructing to acquire a wavy shape is input to the deformability evaluation apparatus. The process then proceeds to the outer shape acquiring step (described below).

Each of the steps will now be described in detail.

<Outer shape Acquiring Step>

The outer shape acquiring step is the step of acquiring the outer shape of a steel pipe by measuring the shape of the steel pipe using, for example, a laser tracker or scanner, or by photographing the shape of the steel pipe and measuring the shape of the steel pipe using the photographed image. Note that the wavy shape of the outer shape refers to a wavy shape measured in the pipe axis direction of the steel pipe.

In the case of a steel pipe manufactured through a pipe expanding step performed using a die, the shape of a steel pipe 1 may have, as illustrated in Fig. 2, a wavy shape with a wavelength and an amplitude. This is just as in the case of Fig. 10 where pipe expansion is performed, for example, with a pitch of 450 mm. In the example of Fig. 10, the steel pipe has an outside diameter of 609 mm ($\phi$609 mm) and a wall thickness of 17.5 mm (t17.5 mm).

When a steel pipe of the same size as that for Fig. 10 is subjected to pipe expansion with a pitch of, for example, 80 mm, the resulting superimposition of wavy shapes produces a random wavy shape, such as that shown in Fig. 11, instead of a wavy shape with a specific amplitude and wavelength.

<Power Spectrum Acquiring Step>

The power spectrum acquiring step is the step of acquiring a power spectrum from the wavy shape of the outer shape of the steel pipe acquired in the outer shape acquiring step.

The power spectrum can be acquired in the following way.

A discrete Fourier transform is given by the following equation:

[Equation 1]

$$F_{(x)} = \frac{1}{N} \sum_{j=0}^{N-1} f_{(z)} e^{-i\frac{2\pi x j}{N}}$$

where N is the number of data and the complex Fourier coefficient f(z) is shape data normalized to a mean of 0.

The amplitude (or irregularity value in the Z direction), $P_{(x)}$, at each frequency (or wavelength here) can be represented by a power spectrum as follows:

[Equation 2]

$$P_{(x)} = \left| F_{(x)} \right|^2$$

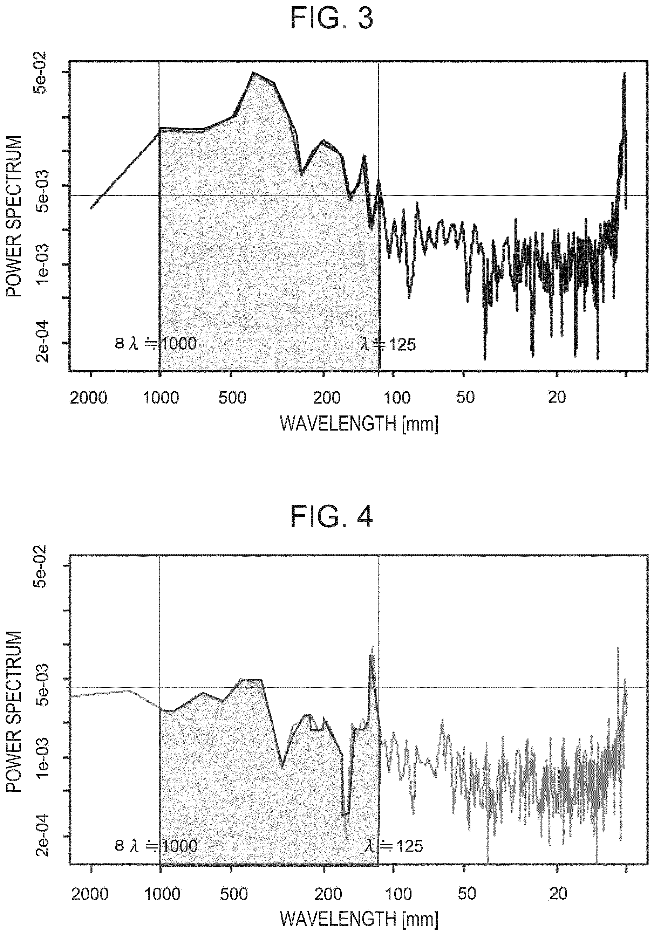

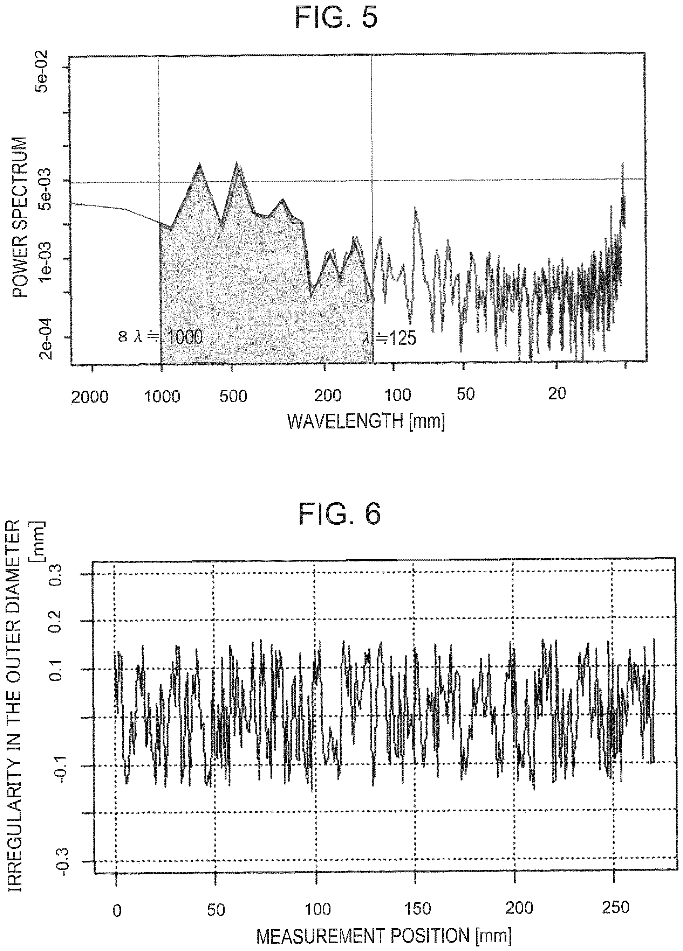

Power spectra determined by the equation described above are shown in Figs. 3 to 5. Fig. 3 is a graph showing a power spectrum obtained when the pipe expansion pitch is 450 mm, Fig. 4 is a graph showing a power spectrum obtained when the pipe expansion pitch is 125 mm, and Fig. 5 is a graph showing a power spectrum obtained when the pipe expansion pitch is 80 mm. Figs. 3 to 5 are graphs all showing a power spectrum obtained, for example, for a steel pipe with an outside diameter of 609 mm ($\phi$609 mm) and a wall thickness of 17.5 mm (t17.5 mm).

In Figs. 3 to 5, the vertical axis represents the power spectrum, and the horizontal axis represents the wavelength (mm).

Referring to Fig. 3, the power spectrum is very high at a wavelength of 450 mm. This is because the power spectrum has a predominant period at 450 mm.

Referring to Fig. 4, the spectrum is high at a wavelength of 125 mm. At a wavelength of 450 mm, the spectrum is lower, but does not completely disappear. The power spectrum at a wavelength of 450 mm is still higher than that in its neighboring wavelength components. This is because the die has an effective length of 450 mm and even when the pipe expansion pitch is 125 mm, it is still true that plastic working is repeated with a 450 mm pitch. That is, even though the wavelength of 450 mm can be reduced to some extent to prevent it from becoming predominant, this does not mean that a single wavelength of 125 mm can be achieved by repetition of pipe expansion.

Referring to Fig. 5, the spectrum is low at a wavelength of 450 mm, as in the case of a pipe expansion pitch of 125 mm in Fig. 4. As compared to the case of a pipe expansion pitch of 125 mm in Fig. 4, the peak is shifted to the shorter wavelength (or to the right along the horizontal axis), the wavelength is shorter, and the power spectrum is lower. That is, Fig. 5 shows that the steel pipe is a smoother steel pipe with a smaller amplitude. The power spectrum at a wavelength of 450 mm is high, to a certain extent, and is highest among peaks in the power spectrum. That is, in the case of a pipe expansion pitch of 80 mm in Fig. 5, the wavelength of 450 mm can be reduced to a level which does not predominantly determine the shape, just as in the case of a pipe expansion pitch of 125 mm in Fig. 4.

<Determining Step>

The determining step is the step of integrating the power spectrum acquired in the power spectrum acquiring step for a predetermined wavelength range, and determining deformability of the steel pipe on the basis of the resulting integral.

Here, the predetermined wavelength range is from an upper limit of 8λ (about 1000 mm) to a lower limit of λ (about 125 mm). The numerical values in the parentheses are values obtained when, for example, the steel pipe has an outside diameter of 609 mm (0609 mm) and a wall thickness of 17.5 mm (t17.5 mm), as described above.

Note that λ described above is a Timoshenko's buckling half-wavelength and can be expressed as $\lambda = 1.72\sqrt{(rt)}$, where r is a radius and t is a wall thickness.

An integral I of the power spectrum can be given by the following equation.

[Equation 3]

$$I = \int_{\lambda}^{8\lambda} P_{(x)}\,dx$$

In Figs. 3 to 5, the integration range in the power spectrum is indicated in gray.

The upper limit is set to 8λ, because it is generally unlikely that the wavelength produced in the shape of the steel pipe, by pipe expansion performed using the die, will exceed 8λ. Steel pipes that are currently manufactured and required to be subjected to pipe expansion are primarily of sizes ranging from 16 inches to 56 inches. From the viewpoint of a width to which pipe expansion can be made by a die typically used, the upper limit 8λ is, for example, 1000 mm in the case of a 24-inch steel pipe with a wall thickness of 17 mm (t17 mm).

The lower limit is set as λ, because with this wavelength or shorter, the wavy shape has less influence on the occurrence of buckling. The lower limit is preferably 2λ. From the viewpoint of Timoshenko's buckling wavy shape, for example, the lower limit λ is 125 mm in the case of a 24-inch steel pipe with a wall thickness of 17 mm (t17 mm), whereas the lower limit λ is 55 mm in the case of a 16-inch steel pipe with a wall thickness of 5 mm (t5 mm), which is a steel pipe in the smallest-diameter and smallest-wall-thickness class among those currently manufactured.

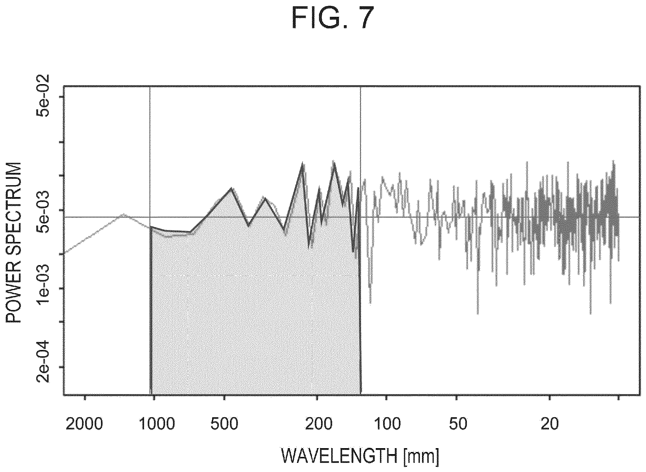

In determining the deformability on the basis of the integral of the power spectrum representing the wavy shape of the shape of the steel pipe, it is preferable to create a random wave with no specific amplitude, for example, as shown in Fig. 6, determine a power spectrum $I_0$ of the random wave, and normalize it into $I/I_0$ as in Fig. 7, where I is a power spectrum representing the wavy shape of the steel pipe.

Fig. 8(a) shows an integral for the integration range in the power spectrum of the random wave, Fig. 8(b) shows an integral for the integration range in the power spectrum obtained when the pipe expansion pitch is 450 mm, Fig. 8(c) shows an integral for the integration range in the power spectrum obtained when the pipe expansion pitch is 125 mm, and Fig. 8(d) shows an integral for the integration range in the power spectrum obtained when the pipe expansion pitch is 80 mm.

The determining step is for determining the bending performance of the steel pipe on the basis of the integral obtained by normalizing the integration range. The smaller the resulting integral, the higher the evaluation of deformability of the steel pipe. This is verified in EXAMPLE described below.

Specifically, if the resulting integral is less than or equal to a predetermined value, it is determined that the steel pipe has high deformability, whereas if the resulting integral is greater than (or exceeds) the predetermined value, it is determined that the steel pipe does not satisfy the required level of deformability.

As described above, with the present embodiment, it is possible to accurately determine the deformability of the steel pipe even when, for example, the pipe expansion pitch is small and the resulting superimposed wavy shape of the outer shape of the steel pipe appears as a random wave.

A method of manufacturing steel pipe will now be described. The method of manufacturing steel pipe is for manufacturing a steel pipe on the basis of the method of evaluating deformability of steel pipe according to the present invention.

In the method of manufacturing steel pipe according to the present invention, if it is determined, in the determining step of the deformability evaluation method described above, that the deformability does not satisfy a predetermined level, the pipe expansion pitch in the pipe expanding step performed using a die is reduced.

For example, in a forming step, a steel plate is formed into a cylindrical shape by a bending press method in which, by a punch having an outer periphery with an arc-shaped cross section at an end portion thereof, pressure is applied to the steel plate in such a manner that edges of the steel plate in the width direction face each other. Next, in a welding step, the edges of the steel plate in the width direction are butt-welded together. Next, in a pipe expanding step, the steel pipe is expanded from inside using a pipe expander with a plurality of pipe expanding dies circumferentially arranged and each having an outer periphery arc-shaped in cross section. Then, the deformability evaluation apparatus, described above, performs the outer shape acquiring step of acquiring a wavy shape of the outer shape of the resulting steel pipe, the power spectrum acquiring step of acquiring a power spectrum from the acquired wavy shape of the outer shape, and the determining step of determining deformability of the steel pipe.

EXAMPLE

An experiment was performed to verify that deformability of a steel pipe can be determined using the integral I of the power spectrum described in the embodiment. The experiment will now be described.

The experiment involved performing a plurality of pipe expanding methods by varying the pipe expansion pitch and the amplitude of the outer shape, and examining, for each of the pipe expanding methods, the relationship between the normalized integral and the bending angle under buckling.

The pipe expanding methods and the results of the examination are as shown in the following table.

[Table 1]

| No. | Pipe Expansion Pitch | Amplitude | Bending Angle under Buckling (deg.) | Normalized Integral of Power Spectrum |
|---|---|---|---|---|
| 1 | 450 mm uniform | ±0.02 mm | 27.7 | 0.27 |
| 2 | Same as above | ±0.1 mm | 25.5 | 0.45 |
| 3 | Same as above | ±0.2 mm | 22.1 | 0.86 |
| 4 | 80 mm uniform | ±0.02 mm | 30.1 | 0.14 |
| 5 | Same as above | ±0.1 mm | 28.1 | 0.24 |

(continued)

| No. | Pipe Expansion Pitch | Amplitude | Bending Angle under Buckling (deg.) | Normalized Integral of Power Spectrum |
|---|---|---|---|---|
| 6 | Same as above | ±0.2 mm | 25.4 | 0.64 |
| 7 | 125 mm uniform | ±0.02 mm | 30.1 | 0.14 |
| 8 | Same as above | ±0.2 mm | 26.2 | 0.52 |

Of Nos. 1 to 8 shown in Table 1, the pipe expanding methods currently used in practice are Nos. 3, 4, and 7. The other pipe expanding methods were performed, as simulations, for filling the gaps between Nos. 3, 4, and 7 by varying the amplitude. Note that the bending angle under buckling shown in Table 1 is the result of an analysis which simulates a test where the steel pipe is bent and buckled under an internal pressure of 60% specified minimum yield strength (SMYS) (X70).

The relationship between the bending angle under buckling and the normalized integral of the power spectrum, shown in Table 1, is represented by the graph of Fig. 9.

The graph of Fig. 9 shows that "bending angle under buckling" and normalized "integral of power spectrum" are substantially inversely proportional, except that the relationship between them is reversed between No.2 and No. 8. That is, when the normalized integral of the power spectrum is used as an index, it is possible to determine that as the integral of the power spectrum decreases, the deformability of the steel pipe is improved.

Although No.3 and No.8 show the same amplitude, ±0.2 mm, the integral is smaller and the bending angle under buckling is larger in No.8. This suggests that the deformability may vary from one steel pipe to another even when their outer shapes have the same amplitude, and that deformability determination, which cannot be made by the conventional technique based only on the outer shape, is successfully made using the invention of the present application.

The outer shapes obtained in the cases of a pipe expansion pitch of 80 mm in No.4 and a pipe expansion pitch of 125 mm in No.7 have a wavelength component of 450 mm, which is reduced to a level which does not predominantly determine the shape, as described above. This means that even when the outer shape has a wavelength of 450 mm, the deformability of the steel pipe can be improved if the amplitude component of the wavelength of 450 mm can be reduced or distributed to a different frequency component.

A conventional method used to improve deformability (buckling performance) is based on the concept of having no specific wavelength or setting no specific difference between the minimum and maximum diameters at pipe ends. With this concept, however, it is difficult to define the performance of steel pipes with outer shapes having complex wavy shapes, such as those obtained in the cases of pipe expansion pitches of 80 mm and 125 mm. Since steel pipes that are generally manufactured have various amplitudes in a broad frequency band, it is difficult, with this conventional concept, to improve or evaluate the performance of typical steel pipes.

However, the findings show that even in the case of having a specific wavelength, the deformability of the steel pipe can be improved if the amplitude component of the specific wavelength can be reduced or the specific wavelength can be distributed to a different frequency component. It is thus possible, with the present invention, to improve or evaluate the performance of steel pipes generally manufactured.

The results of EXAMPLE show that to improve deformability of the steel pipe, it is only necessary to reduce the pipe expansion pitch to about 125 mm, or to modify the die in such a manner that the amplitude of the outer shape obtained by pipe expansion is ±0.1 mm or less.

With this determining method of the present invention, it is possible not only to determine deformability of the steel pipe, but also to provide guidelines for improving the deformability of the steel pipe in terms of the pipe expanding method using the die.

As described above, the outer shape of the manufactured steel pipe can be acquired by online measurement using, for example, a laser tracker or scanner. Therefore, steel pipes with high deformability can be manufactured, as needed, by sequentially measuring the outer shapes during manufacture, performing the determining method of the present invention on the basis of the measurement results, and providing the determination result as feedback to the pipe expansion control. This can therefore improve the yield of products.

An example of the feedback may be that if it is determined that the deformability of the steel pipe does not satisfy a predetermined level, the pipe expansion pitch used in the pipe expanding step performed using the die is reduced.

Reference Signs List

1    steel pipe

## Claims

1.  A method of evaluating deformability of steel pipe manufactured through a pipe expanding step performed using a die, the method of evaluating deformability of steel pipe comprising:

    a outer shape acquiring step of measuring a shape of the steel pipe to acquire a wavy shape of a outer shape;
    a power spectrum acquiring step of acquiring a power spectrum from the acquired wavy shape of the outer shape; and
    a determining step of integrating the acquired power spectrum for a predetermined wavelength range and determining deformability of the steel pipe on the basis of the resulting integral.

2.  The method of evaluating deformability of steel pipe according to Claim 1, wherein if the integral is less than or equal to a predetermined value, the determining step determines that a predetermined deformability level is satisfied.

3.  A method of manufacturing steel pipe on the basis of the method of evaluating deformability of steel pipe according to Claim 1 or 2,
    wherein if the determining step of the method of evaluating deformability of steel pipe determines that the deformability does not satisfy a predetermined deformability level, a pipe expansion pitch in the pipe expanding step performed using the die is reduced.

## Patentansprüche

1.  Verfahren zum Bewerten von Verformbarkeit von Stahlrohr, das mittels eines Schritts zum Rohraufweiten hergestellt wird, der unter Verwendung eines Werkzeugs durchgeführt wird, wobei das Verfahren zum Bewerten von Verformbarkeit von Stahlrohr umfasst:

    einen Schritt zum Erfassen einer äußeren Form, in dem eine Form des Stahlrohrs gemessen wird, um eine Wellenform einer äußeren Form zu erfassen;
    einen Schritt zum Erfassen eines Leistungsspektrums, in dem ein Leistungsspektrum anhand der erfassten Wellenform der äußeren Form erfasst wird; und
    einen Schritt zum Feststellen, in dem das erfasste Leistungsspektrum für einen vorgegebenen Wellenlängenbereich integriert wird und Verformbarkeit des Stahlrohrs auf Basis des resultierenden Integrals festgestellt wird.

2.  Verfahren zum Bewerten von Verformbarkeit von Stahlrohr nach Anspruch 1, wobei, wenn das Integral kleiner ist als oder genauso groß wie ein vorgegebener Wert, mit dem Schritt zum Feststellen festgestellt wird, dass ein vorgegebener Verformbarkeitsgrad erreicht ist.

3.  Verfahren zum Herstellen von Stahlrohr auf Basis des Verfahrens zum Bewerten von Verformbarkeit von Stahlrohr nach Anspruch 1 oder 2,
    wobei, wenn mit dem Schritt zum Feststellen des Verfahrens zum Bewerten von Verformbarkeit von Stahlrohr festgestellt wird, dass die Verformbarkeit einen vorgegebenen Verformbarkeitsgrad nicht erreicht, ein Rohraufweitungs-Maß in dem unter Verwendung des Werkzeugs durchgeführten Schritt zum Rohraufweiten reduziert wird.

## Revendications

1.  Procédé d'évaluation de la déformabilité d'un tuyau en acier fabriqué par une étape d'agrandissement de tuyau effectuée en utilisant une matrice, le procédé d'évaluation de la déformabilité d'un tuyau en acier comprenant :

    une étape d'acquisition de forme extérieure consistant à mesurer une forme du tuyau en acier pour acquérir une forme ondulée d'une forme extérieure ;
    une étape d'acquisition de spectre de puissance consistant à acquérir un spectre de puissance à partir de la forme ondulée acquise de la forme extérieure ; et
    une étape de détermination consistant à intégrer le spectre de puissance acquis pour une plage de longueurs d'onde prédéterminée et à déterminer la déformabilité du tuyau en acier sur la base de l'intégrale résultante.

2. Procédé d'évaluation de la déformabilité d'un tuyau en acier selon la revendication 1, dans lequel si l'intégrale est inférieure ou égale à une valeur prédéterminée, l'étape de détermination détermine qu'un niveau de déformabilité prédéterminé est satisfait.

3. Procédé de fabrication d'un tuyau en acier sur la base du procédé d'évaluation de la déformabilité d'un tuyau en acier selon la revendication 1 ou 2,
dans lequel si l'étape de détermination du procédé d'évaluation de la déformabilité d'un tuyau en acier détermine que la déformabilité ne satisfait pas un niveau de déformabilité prédéterminé, un pas d'agrandissement de tuyau dans l'étape d'agrandissement de tuyau effectuée en utilisant la matrice est réduit.

# FIG. 1

```
        ┌─────────────┐
        │    START    │
        └──────┬──────┘
               │
               ▼
┌──────────────────────────────────┐
│    OUTER SHAPE ACQUIRING STEP     │
└──────────────────┬───────────────┘
                   │
                   ▼
┌──────────────────────────────────┐
│  POWER SPECTRUM ACQUIRING STEP    │
└──────────────────┬───────────────┘
                   │
                   ▼
┌──────────────────────────────────┐
│          DETERMINING STEP         │
└──────────────────┬───────────────┘
                   │
                   ▼
            ┌─────────────┐
            │     END     │
            └─────────────┘
```

# FIG. 2

# FIG. 3

# FIG. 4

## FIG. 5

## FIG. 6

## FIG. 7

# FIG. 8

(a)

$I_0$

RANDOM

(b)

450 mm PITCH

(c)

125 mm PITCH

(d)

80 mm PITCH

## FIG. 9

## FIG. 10

# FIG. 11

**EP 3 560 617 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5447461 B